# EUROPÄISCHE PATENTSCHRIFT

(11) **EP 1 804 346 B1**
(45) Veröffentlichungstag und Bekanntmachung des Hinweises auf die Patenterteilung: **06.05.2009**
(21) Anmeldenummer: 06023441.6
(22) Anmeldetag: 10.11.2006
(51) Int. Cl.: H01R 13/66, H02G 3/12, H01H 9/02

(54) **Elektrisches / elektronisches Installationsgerät**
Electric / electronic installation apparatus
Appareil électrique / électronique d' installation

(30) Priorität: 27.12.2005 DE 102005062494
(43) Veröffentlichungstag der Anmeldung: 04.07.2007
(73) Patentinhaber: Albrecht Jung GmbH & Co. KG, 58579 Schalksmühle (DE)
(72) Erfinder: Ullrich, Konrad, Dipl.-Ing., 58339 Breckerfeld (DE); Kandt, Richard, Dipl.-Ing, 44803 Bochum (DE); Gebhardt, Marc Dipl.-Ing., 58579 Schalksmühle (DE)

(56) Entgegenhaltungen:
- EP-A2- 1 298 845
- US-A- 4 288 787

## Beschreibung

Die vorliegende Erfindung geht von einem gemäß Oberbegriff des Hauptanspruches konzipierten elektrischen/elektronischen Installationsgerät aus.

Derartige elektrische/elektronische Installationsgeräte sind in der Regel dafür vorgesehen, eine Vielzahl von in Gebäuden installierten Aktoren (Jalousieantriebe, Beleuchtungseinrichtungen, Fühler, Wächter usw.) bedarfsgerecht zu beeinflussen. Zu diesem Zweck sind die unterschiedlichsten Installationseinrichtungen, wie Schalter, Taster, Dimmer usw. bekannt geworden.

Durch die EP 1 298 845 A2 ist ein dem Oberbegriff des Hauptanspruches entsprechendes elektrisches/elektronisches Installationsgerät für die Gebäudesystemtechnik bekannt geworden. Dieses elektrische/elektronische Installationsgerät für die Gebäudesystemtechnik weist eine beidseitig bestückte Leiterplatte auf, wobei die in Rede stehende Leiterplatte auf der Oberseite Bauteile für die Bedienung aufweist und auf der Unterseite ein Bauteil eines Busankopplers vorgesehen ist. Beim betreffenden Installationsgerät ist ein separates Unterputzmodul vorgesehen, welches für den Busbetrieb zwingend notwendig ist. Aus diesem Grunde weist die doppelseitig bestückte Leiterplatte eine erste Schnittstelle zum Installationsbus und eine zweite Schnittstelle zum Unterputzmodul auf. Eindeutig sind somit nicht alle für den Busbetrieb notwendigen Funktionsbauteile auf der doppelseitig bestückten Leiterplatte angeordnet. Vielmehr ist es für den Busbetrieb zwingend notwendig, zusätzlich das separate Unterputzmodul anzukoppeln, was einerseits einen entsprechend höheren produktionstechnischen und vertriebstechnischen Aufwand erfordert und andererseits bei der Installation in eine Unterputzdose entsprechend mehr an Bauraum in Anspruch nimmt.

Des weiteren ist durch die DE 40 00 623 A1 ein elektrisches/elektronisches Installationsgerät für die Gebäudesystemtechnik bekannt geworden, bei dem eine Leiterplatte vorgesehen ist, auf dessen Oberseite alle zur Bedienung der zugeordneten Aktoren notwendigen Funktionselemente angeordnet sind. Außerdem weist dieses elektrische/elektronische Installationsgerät eine separate Funktionsbaugruppe auf, welche über eine Steckverbindung mit der Unterseite der elektrischen Leiterplatte verbindbar ist. Diese Funktionsbaugruppe weist alle für den Betrieb in einem Bussystem notwendigen Funktionsbauteile auf. Eine solche Ausbildung eines elektrischen/elektronischen Installationsgerät hat jedoch nicht nur einen beachtlichen Raumbedarf zur Folge, sondern ist wegen der vergleichsweise hohen Anzahl von Einzelteilen sowohl aufwendig in ihrer Herstellung, als auch bei der Installation im Gebäude. Zudem ist das Design eines solchen elektrischen/elektronischen Installationsgerätes stark abhängig von der Lage seiner einzelnen Komponenten in Bezug auf die Wandebene. Die Bedienelemente tragen beim Einsatz in eine übliche Installationsdose aus diesem Grund relativ hoch auf die Wandebene auf.

Zudem ist durch die US 4 288 787 A ein elektrisches Schaltgerät bekannt geworden, bei dem auf der Oberseite der zugehörigen Leiterplatte die Bestückungsplätze der vorgesehenen Schaltelemente matrixartig angeordnet sind.

Ausgehend von derart ausgebildeten elektrischen/elektronischen Installationsgeräten liegt der vorliegenden Erfindung die Aufgabe zugrunde, ein Installationsgerät zu schaffen, das nicht nur besonders kompakt ausgeführt ist, sondern dessen Herstellung und Installation eine besonders einfache und kostengünstige Handhabung ermöglicht.

Erfindungsgemäß wird diese Aufgabe durch die im Hauptanspruch angegebenen Merkmale gelöst.

Bei einer solchen Ausbildung ist besonders vorteilhaft, dass durch die matrixartige Anordnung der Funktionselemente auf der Oberseite der Leiterplatte besonders flexible Auswahlmöglichkeiten hinsichtlich der Bestückung mit verschiedenartig ausgeführten Bedienelementen, Anzeigeeinrichtungen, sensorische Anordnungen, wie Wächter usw. besteht. Außerdem ist besonders vorteilhaft, dass eine große Designfreiheit dadurch gegeben ist, weil die Leiterplatte mit ihren Bedienelementen in Bezug auf die Wandebene nur relativ geringfügig bzw. überhaupt nicht aufträgt.

Weitere vorteilhafte Ausgestaltungen des erfindungsgemäßen Gegenstandes sind in den Unteransprüchen angegeben. Anhand eines Ausführungsbeispiels sei die Erfindung im Prinzip näher erläutert, dabei zeigt:
- Fig. 1:: prinziphaft ein solches elektrisches/elektronisches Installationsgerät in Explosionsdarstellung;
- Fig. 2:: prinziphaft die Leiterplatte eines solchen elektrischen/elektronischen Installationsgeräts, in räumlicher Darstellung schräg von oben gesehen;
- Fig. 3:: prinziphaft die Leiterplatte eines solchen elektrischen/elektronischen Installationsgeräts, in räumlicher Darstellung schräg von unten gesehen;
- Fig. 4:: prinziphaft die Installationsposition einer ersten Ausführungsform eines solchen elektrischen/elektronischen Installationsgeräts in einer handelsüblichen Installationsdose;
- Fig. 5:: prinziphaft die Installationsposition einer zweiten Ausführungsform eines solchen elektrischen/elektronischen Installationsgeräts in einer handelsüblichen Installationsdose.

Wie aus den Figuren hervorgeht, besteht ein solches elektrisches/elektronisches Installationsgerät für die Gebäudesystemtechnik hauptsächlich aus einer Leiterplatte 1, die von einem Gehäuse 2 aufgenommen ist. Das Gehäuse 2 ist mit einem Tragring 3 umgeben. Über den Tragring 3 wird das elektrische/elektronische Installationsgerät an einer normalen, d. h. übliche Abmessungen aufweisende Installationsdose D festgelegt. Auf der Oberseite 4 der Leiterplatte 1 sind alle zur Bedienung der zugeordneten Aktoren notwendigen Funktionselemente angeordnet.

Die Unterseite 5 der Leiterplatte 1 weist alle für den Betrieb in einem Bussystem notwendigen Funktionsbauteile auf.

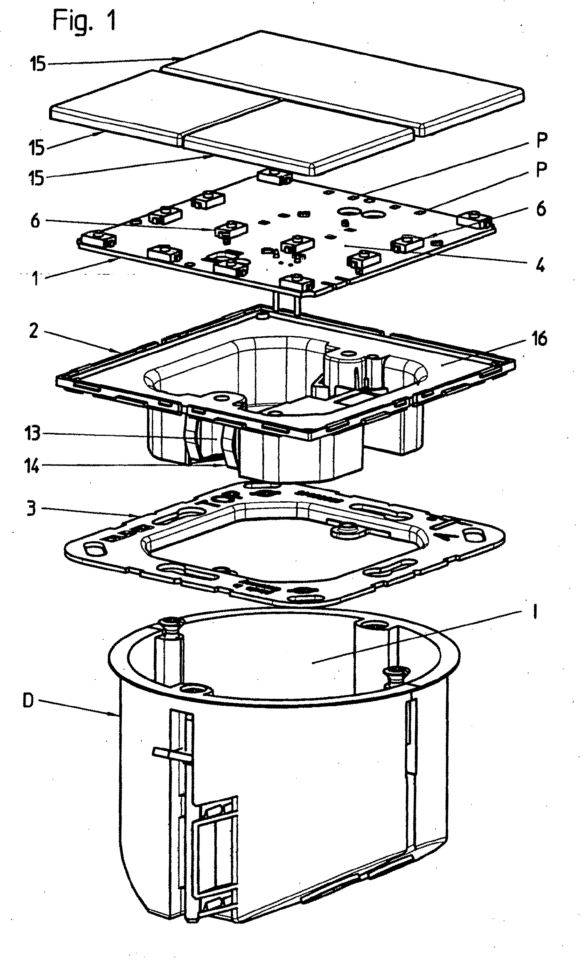

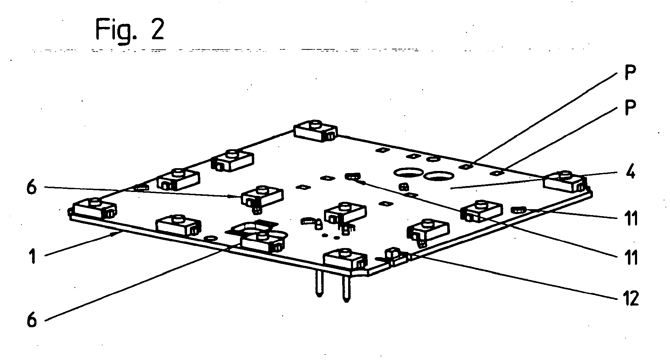

Wie des weiteren insbesondere aus Figur 1 und Figur 2 hervorgeht, sind auf der Oberseite 4 der Leiterplatte 1 die zur Beeinflussung der Aktoren notwendigen Funktionselemente vorhanden. Mehrere Funktionselemente sind als Schaltelemente 6 ausgebildet, die in einer Matrix angeordnet auf der Oberseite 4 der Leiterplatte 1 vorhanden sind. Wesentlich ist dabei, dass alle Bestückungsplätze P der zur Beeinflussung der Aktoren notwendigen Schaltelemente 6 matrixartig auf der Oberseite 4 der Leiterplatte 1 angeordnet sind, damit hinsichtlich der Funktionen eine große Flexibilität gewährleistet ist. Bei diesem Ausführungsbeispiel sind alle Schaltelemente 6 als Mikroschalter bzw. als Mikrotaster ausgeführt. Es ist jedoch genau so gut eine Ausführung der Schaltelemente 6 als Dome einer Domschaltmatte möglich. Auch eine kombinierte Bestückung mit Domschaltmatte und Mikroschaltern bzw. Mikrotastern ist ohne weiteres vorstellbar.

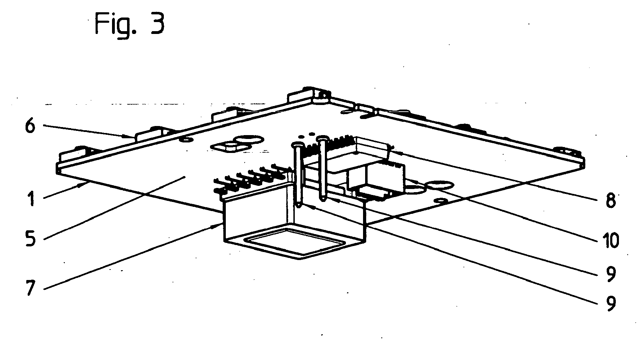

Wie insbesondere aus Figur 3 hervorgeht, sind auch der Unterseite 5 der einzigen Leiterplatte 1 alle für den Betrieb in einem Bussystem notwendigen Funktionsbauteile angeordnet. Wie des weiteren insbesondere aus Figur 3 hervorgeht, ist eines der auf der Unterseite 5 der Leiterplatte 1 angeordneten Funktionsbauteile als Busankoppler 7 und eines als Speicher 8 für die Anwendungssoftware ausgebildet. Zudem sind zwei Steckerstifte 9 für die Installations- bzw. den Anschluss der Busleitungen sowie ist eine Steckerkupplung 10 zur Anbindung von Nebenstellen vorgesehen.

Wie des weiteren insbesondere aus Figur 1 und Figur 2 hervorgeht, sind vier der sechzehn auf der Oberseite 4 der Leiterplatte 1 angeordneten Schaltelementen 6 jeweils zwei LEDs 11 zugeordnet. Die LEDs 11 sind, wie die Schaltelemente 6 im Rahmen der Matrixanordnung auf der Oberseite 4 der Leiterplatte 1 vorhanden. Ein weiteres als Temperatursensor 12 ausgebildetes Funktionselement ist zudem auf der Oberseite 4 der Leiterplatte 1 vorhanden, welches jedoch außerhalb der Matrixanordnung platziert ist. Das die Leiterplatte 1 aufnehmende Gehäuse 2 ist von einem Tragring 3 umgeben, der zur Befestigung des elektrischen/elektronischen Installationsgerätes an einer Installationsdose D vorgesehen ist. Um eine einfache und schnelle Montage des elektrischen/elektronischen Installationsgerätes zu gewährleisten, weist das Gehäuse 2 zwei eingeformte Aufnahmezonen 13 auf, in welchem jeweils eine Haltefeder 14 rastend festgelegt ist. Zur Positionssicherung des elektrischen/elektronischen Installationsgerätes kommen die streifenförmig ausgebildeten Federschenkel der beiden Haltefedern 14 mit entsprechend ausgebildeten Haltebereichen des Tragrings 3 in Wirkverbindung.

Wie des weiteren insbesondere aus Figur 1 hervorgeht, sind der Oberseite 4 der Leiterplatte 1 zwei quadratisch ausgebildete Betätigungstasten 15 und eine rechteckig ausgeführte Betätigungstaste 15 zugeordnet. Durch die matrixartige Anordnung der Schaltelemente kann die Anordnung der Betätigungstasten 15 beliebig vorgenommen werden, d. h. auch nach der Installation ist eine anwenderbezogene Anordnung der Betätigungstasten 15 ohne weiteres möglich. Dies bedeutet, dass die jetzt auf der rechten Seite angeordnete rechteckige große Betätigungstaste 15 z. B. auf der linken oder auf der unteren oder auf der oberen Position, je nach Wunsch des Anwenders angeordnet werden kann und die freigegebenen Positionen entweder durch eine weitere rechteckige große Betätigungstaste 15 oder aber durch zwei quadratische kleine Betätigungstasten 15 aufgefüllt werden. Selbstverständlich sind auch andere Anordnungen möglich bzw. es können auch andere Funktionselemente, wie z. B. eine Anzeigeeinheit, ein Bewegungsmelder und dergleichen der Oberseite 4 der Leiterplatte 1 zugeordnet werden.

Ohne weiteres ist somit ein hinsichtlich der Funktionen bzw. der Anwenderwünsche hochflexibeler Aufbau eines solchen elektrischen/elektronischen Installationsgerätes realisiert.

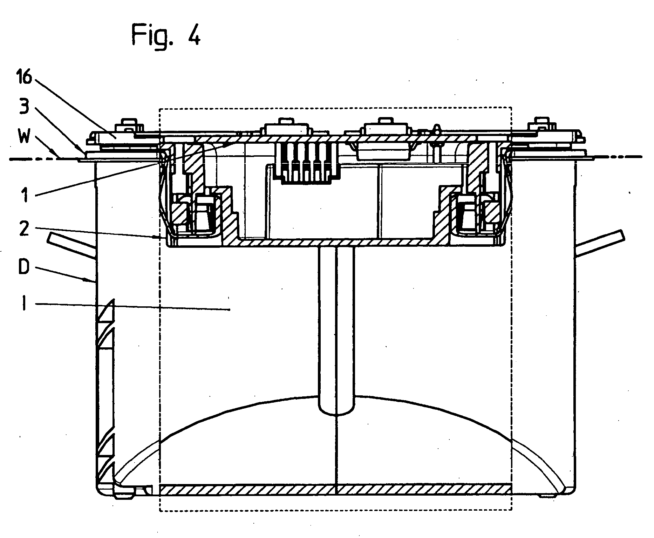

Wie des weiteren insbesondere aus Figur 1 und Figur 4 hervorgeht, ist der untere Teil des, die Leiterplatte 1 mit ihren Funktionsbauteilen aufnehmenden Gehäuses 2 derartig ausgebildet bzw. bemessen, dass die Einführung in den Innenraum I einer normale Abmessungen aufweisenden, handelsüblichen Installationsdose D möglich ist. D. h. der Flanschbereich 16 des Gehäuses 2 kommt bei der Installation lediglich unter Zwischenschaltung des Tragrings 3 auf der Wand W zur Anlage. Der gesamte andere Bereich des Gehäuses 2 wird jedoch gänzlich in die Installationsdose D hineingeschoben, wobei die Leiterplatte ihrerseits gänzlich in den Flanschbereich 16 des Gehäuses 2 eintaucht. Durch eine solche Ausbildung ist somit gewährleistet, dass das elektrische/elektronische Installationsgerät nur minimal auf die Wand W aufbaut.

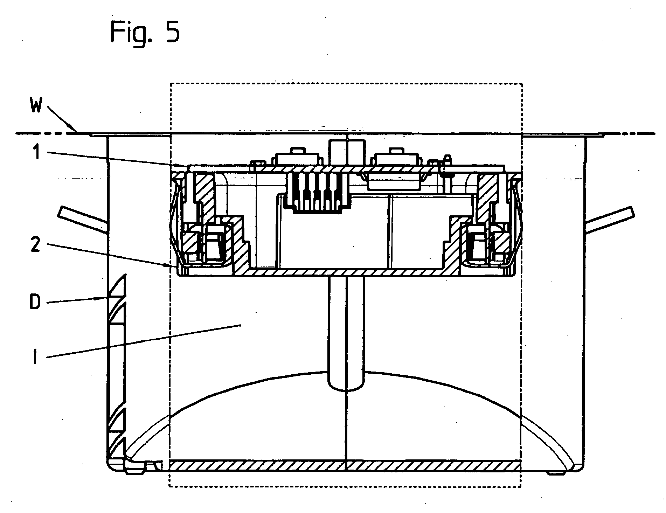

Wie insbesondere aus Figur 5 hervorgeht, weist das gesamte Gehäuse 2 mit der aufgenommenen Leiterplatte 1 und deren Funktionsbauteile derartige Außenabmessungen auf, so dass die Einführung dieser Anordnung insgesamt in den Innenraum I einer normale Abmessungen aufweisenden, handelsüblichen Installationsdose D möglich ist. D. h. das Gehäuse 2 und die oberhalb der Leiterplatte 1 angeordneten Funktionselemente verschwinden gänzlich im Innenraum I der Installationsdose D. Die Oberseiten der, der Einfachheit halber nicht dargestellten Betätigungstasten können also eine Ebene mit der Wand W bilden oder aber unterhalb der Wandebene angeordnet sein. Durch eine solche Ausbildung ist somit gewährleistet, dass das elektrische/elektronische Installationsgerät mit der Wandebene abschließt, bzw. zumindest nicht auf die Wand W aufbaut.

## Patentansprüche

1. Elektrisches/elektronisches Installationsgerät für die Gebäudesystemtechnik mit einer doppelseitig bestückten Leiterplatte auf dessen Oberseite alle zur Bedienung und/oder zur Informationsweitergabe notwendigen Funktionselemente angeordnet sind und auf dessen Unterseite ein Bauteil eines Busankopplers vorgesehen ist, **dadurch gekennzeichnet, dass** auf der Unterseite (5) der doppelseitig bestückten Leiterplatte (1) alle für den Betrieb in einem Bussystem notwendigen Funktionsbauteile angeordnet sind, und dass zumindest ein auf der Unterseite (5) der Leiterplatte (1) angeordnetes Funktionsbauteil als Busankoppler (7) ausgeführt ist, und dass für den Betrieb in einem Bussystem auf der Unterseite (5) der Leiterplatte (1) lediglich ein Anschluss mit zwei Steckerstiften (9) für die Busleitungen vorgesehen ist.

2. Elektrisches/elektronisches Installationsgerät nach Anspruch 1, **dadurch gekennzeichnet, dass** zumindest die Bestückungsplätze (P) der zur Beeinflussung der Aktoren vorgesehenen Schaltelemente (6) matrixartig auf der Oberseite (4) der Leiterplatte (1) angeordnet sind.

3. Elektrisches/elektronisches Installationsgerät nach Anspruch 1 oder 2, **dadurch gekennzeichnet, dass** zumindest einem Schaltelement (6) ein als LED (11) ausgebildetes Funktionselement zugeordnet ist.

4. Elektrisches/elektronisches Installationsgerät nach einem der Ansprüche 1 bis 3, **dadurch gekennzeichnet, dass** zumindest ein außerhalb der Matrixanordnung liegendes Funktionselement auf der Oberseite (4) der Leiterplatte (1) vorhanden ist.

5. Elektrisches/elektronisches Installationsgerät nach einem der Ansprüche 1 bis 4, **dadurch gekennzeichnet, dass** zumindest ein auf der Unterseite (5) der Leiterplatte (1) angeordnetes Funktionsbauteil als Speicher (8) für die Anwendungssoftware ausgeführt ist.

6. Elektrisches/elektronisches Installationsgerät nach einem der Ansprüche 1 bis 5, **dadurch gekennzeichnet, dass** die Leiterplatte (1) von einem Gehäuse (2) aufgenommen ist.

7. Elektrisches/elektronisches Installationsgerät nach Anspruch 6, **dadurch gekennzeichnet, dass** dem Gehäuse (2) ein Tragring (3) zugeordnet ist.

8. Elektrisches/elektronisches Installationsgerät nach Anspruch 6, **dadurch gekennzeichnet, dass** dem Gehäuse (2) als Haltefedern (14) ausgebildete Befestigungsmittel für die Installation zugeordnet sind.

9. Elektrisches/elektronisches Installationsgerät nach einem der Ansprüche 1 bis 8, **dadurch gekennzeichnet, dass** zumindest eines der, der Oberseite (4) der Leiterplatte (1) zugeordneten Funktionselemente als Betätigungstaste (15) ausgeführt ist.

10. Elektrisches/elektronisches Installationsgerät nach einem der Ansprüche 1 bis 9, **dadurch gekennzeichnet, dass** zumindest eines der, der Oberseite (4) der Leiterplatte (1) zugeordneten Funktionselemente als Anzeigeeinheit ausgeführt ist.

11. Elektrisches/elektronisches Installationsgerät nach einem der Ansprüche 1 bis 10, **dadurch gekennzeichnet, dass** zumindest eines der, der Oberseite (4) der Leiterplatte (1) zugeordneten Funktionselemente als sensorische Anordnung ausgeführt ist.

12. Elektrisches/elektronisches Installationsgerät nach einem der Ansprüche 1 bis 11, **dadurch gekennzeichnet, dass** zumindest der untere Teil des die Leiterplatte (1) mit ihren Funktionsbauteilen aufnehmenden Gehäuse (2) derartige Außenabmessungen aufweist, dass die Einführung in den Innenraum (I) einer normalen Installationsdose (D) möglich ist.

13. Elektrisches/elektronisches Installationsgerät nach einem der Ansprüche 1 bis 11, **dadurch gekennzeichnet, dass** das gesamte Gehäuse (2) mit der aufgenommenen Leiterplatte (1) und deren Funktionsbauteile derartige Außenabmessungen aufweist, so dass die Einführung dieser Anordnung insgesamt in den Innenraum (I) einer normalen Installationsdose (D) möglich ist.

## Claims

1. Electric/electronic installation device intended for building system engineering with a double-sided printed circuit board on the top side of which all the functional elements needed for operating and/or transmitting information are located and on the bottom side of which a component of a bus coupling unit is provided, **characterised in that** all the functional components necessary for operating in a bus system are located on the bottom side (5) of the double-sided printed circuit board (1) and that at least one functional component located on the bottom side (5) of the printed circuit board (1) is designed as a bus coupling unit (7), and that for the purpose of operating in a bus system only one connection with two plug pins (9) for the bus lines is provided on the bottom side (5) of the printed circuit board (1).

2. Electric/electronic installation device in accordance with Claim 1, **characterised in that** at least the mounting positions (P) for the switching elements (6) provided for controlling the actuators are located matrix-like on the top side (4) of the printed circuit board (1).

3. Electric/electronic installation device in accordance with Claim 1 or Claim 2, **characterised in that** a functional element designed as an LED (11) is allocated to at least one switching element (6).

4. Electric/electronic installation device in accordance with any of Claims 1 to 3, **characterised in that** at least one functional element positioned outside the matrix arrangement is provided on the top side (4) of the printed circuit board (1).

5. Electric/electronic installation device in accordance with any of Claims 1 to 4, **characterised in that** at least one functional component located on the bottom side (5) of the printed circuit board (1) is designed as a storage device (8) for the application software.

6. Electric/electronic installation device in accordance with any of Claims 1 to 5, **characterised in that** the printed circuit board (1) is accommodated in a housing (2).

7. Electric/electronic installation device in accordance with Claim 6, **characterised in that** the housing (2) is allocated to a retaining ring (3).

8. Electric/electronic installation device in accordance with Claim 6, **characterised in that** fastening means for installation, which are designed as retaining springs (14), are allocated to the housing (2).

9. Electric/electronic installation device in accordance with any of Claims 1 to 8, **characterised in that** at least one of the functional elements allocated to the top side (4) of the printed circuit board (1) is designed as an actuation button (15).

10. Electric/electronic installation device in accordance with any of Claims 1 to 9, **characterised in that** at least one of the functional elements allocated to the top side (4) of the printed circuit board (1) is designed as a display unit.

11. Electric/electronic installation device in accordance with any of Claims 1 to 10, **characterised in that** at least one of the functional elements allocated to the top side (4) of the printed circuit board (1) is designed as a sensor array.

12. Electric/electronic installation device in accordance with any of Claims 1 to 11, **characterised in that** at least the lower part of the printed circuit board (1) with the housing (2) accommodating its functional components features outside dimensions which facilitate its insertion into the interior (I) of a normal installation box (D).

13. Electric/electronic device in accordance with any of Claims 1 to 11, **characterised in that** the entire housing (2) with the printed circuit board (1) and its functional elements accommodated therein features such outside dimensions that it is possible to insert this arrangement altogether into the interior (I) of a normal installation box (D).

## Revendications

1. Appareil d'installation électrique/électronique pour les installations techniques systémiques des bâtiments et la domotique, avec carte à circuits imprimés équipée des deux côtés, sur le côté supérieur duquel sont placés tous les éléments fonctionnels nécessaires à la commande et/ou à la transmission d'informations, et sur le côté inférieur duquel est prévu un composant de connecteur de bus, **caractérisé en ce que** l'ensemble des éléments fonctionnels nécessaires au fonctionnement dans un système de bus sont placés sur le côté inférieur (5) de la carte à circuits imprimés équipée des deux côtés (1), et **en ce que** au moins un élément fonctionnel placé sur le côté inférieur (5) de la carte à circuits imprimés (1) est réalisé sous forme d'un connecteur de bus (7), et **en ce que**, pour le fonctionnement dans un système de bus, seulement un raccordement avec deux broches mâles (9) pour les lignes du bus est prévu sur le côté inférieur (5) de la carte à circuits imprimés (1).

2. Appareil d'installation électrique/électronique selon la revendication 1, **caractérisé en ce que** au moins les emplacements d'équipement (P) des éléments de commutation (6) prévus pour commander les activateurs sont placés en tableau sur le côté supérieur (4) de la plaque imprimé (1).

3. Appareil d'installation électrique/électronique selon la revendication 1 ou 2, **caractérisé en ce que** un élément de fonctionnement, sous forme de diode électroluminescente (11), est attribué à au moins un élément de commutation (6).

4. Appareil d'installation électrique/électronique selon l'une des revendications 1 à 3, **caractérisé en ce que** au moins un élément fonctionnel situé hors du tableau est présent sur le côté supérieur (4) de la carte à circuits imprimés (1).

5. Appareil d'installation électrique/électronique selon l'une des revendications 1 à 4, **caractérisé en ce que** au moins un élément fonctionnel situé sur le côté inférieur (5) de la carte à circuits imprimés (1) est réalisé sous forme de mémoire (8) pour le logiciel d'application.

6. Appareil d'installation électrique/électronique selon l'une des revendications 1 à 5, **caractérisé en ce que** un boîtier (2) accueille la carte à circuits imprimés (1).

7. Appareil d'installation électrique/électronique selon la revendication 6, **caractérisé en ce que** un anneau support (3) est attribué au boîtier (2).

8. Appareil d'installation électrique/électronique selon la revendication 6, **caractérisé en ce que** sont attribués au boîtier (2), des pièces de fixation de l'installation, réalisées sous forme de ressorts de retenue et de maintien (14).

9. Appareil d'installation électrique/électronique selon l'une des revendications 1 à 8, **caractérisé en ce que** au moins l'un des éléments fonctionnels attribués au côté supérieur (4) de la carte à circuits imprimés (1) est réalisé sous forme d'une touche d'actionnement (15).

10. Appareil d'installation électrique/électronique selon l'une des revendications 1 à 9, **caractérisé en ce que** au moins l'un des éléments fonctionnels attribués au côté supérieur (4) de la carte à circuits imprimés (1) est réalisé sous forme d'une unité d'affichage.

11. Appareil d'installation électrique/électronique selon l'une des revendications 1 à 10, **caractérisé en ce que** au moins l'un des éléments fonctionnels attribués au côté supérieur (4) de la carte à circuits imprimés (1) est réalisé sous forme de groupe de capteurs.

12. Appareil d'installation électrique/électronique selon l'une des revendications 1 à 11, **caractérisé en ce que** au moins la partie inférieure du boîtier (2) accueillant la carte à circuits imprimés (1) avec ses éléments fonctionnels présente des dimensions extérieures telles qu'il est possible de l'introduire dans la cavité intérieure (I) d'une boîte d'installation normale (D).

13. Appareil d'installation électrique/électronique selon l'une des revendications 1 à 11, **caractérisé en ce que**, la totalité du boîtier (2), avec la carte à circuits imprimés qu'il accueille (1) et les éléments fonctionnels de celle-ci, présente des dimensions extérieures telles qu'il est possible d'introduire ce groupe dans sa totalité dans la cavité intérieure (I) d'une boîte d'installation normale (D).
